# EUROPÄISCHE PATENTSCHRIFT

(11) **EP 3 591 680 B1**
(45) Veröffentlichungstag und Bekanntmachung des Hinweises auf die Patenterteilung: **28.06.2023**
(21) Anmeldenummer: 19184801.9
(22) Anmeldetag: 05.07.2019
(51) Int. Cl.: H01H 9/02

(54) **WANDHALTERUNG ZUM HALTEN EINER FERNBEDIENUNG**
WALL MOUNT FOR HOLDING A REMOTE CONTROL
SUPPORT MURAL PERMETTANT DE SUPPORTER UNE TÉLÉCOMMANDE

(30) Priorität: 06.07.2018 DE 102018116490
(43) Veröffentlichungstag der Anmeldung: 08.01.2020
(73) Patentinhaber: fm marketing gmbh, 5202 Obertrum am Wallersee (AT)
(72) Erfinder: Maier, Ferdinand, 5202 Neumarkt am Wallersee (AT)
(74) Vertreter: von Bülow & Tamada

(56) Entgegenhaltungen:
- CN-U- 207 140 967
- FR-A1- 3 029 021
- JP-A- H07 274 269
- JP-A- H07 298 378
- JP-A- 2004 260 466
- JP-A- 2016 158 474
- US-A1- 2014 239 916

## Beschreibung

Die vorliegende Erfindung betrifft eine Wandhalterung zum Halten einer Fernbedienung an einem Tragekörper und ein System mit der Wandhalterung.

Eine Wandhalterung ist aus der US 6,975,223 B1 und der JP H07 298378 A bekannt.

Die Druckschrift CN 207140967 U offenbart eine Wandhalterung zum Halten einer Fernbedienung in einem zylindrischen Aufnahmeraum an einem Tragekörper umfassend eine Mantelwand, die wenigstens teilweise um eine Mantelseite des Aufnahmeraums gelegt ist, eine sich an einer Grundseite des Aufnahmeraums an die Mantelwand anschließende Bodenwand mit einer in den Aufnahmeraum gerichteten Innenseite und einer der Innenseite gegenüberliegenden Außenseite und eine Einsetzöffnung an einer Deckseite des Aufnahmeraumes, über die die Fernbedienung in den Aufnahmeraum einsetzbar ist, wobei durch die Bodenwand zwei Durchgangsöffnungen geführt sind, durch die jeweils ein Befestigungsmittel zur Befestigung der Bodenwand am Tragkörper führbar sind.

Aufgabe der Erfindung ist, die Wandhalterung zu verbessern.

Die Aufgabe wird durch die Merkmale der unabhängigen Ansprüche gelöst.

Bevorzugte Weiterbildungen sind Gegenstand der abhängigen Ansprüche.

Gemäß einem Aspekt der Erfindung, umfasst eine Wandhalterung zum Halten einer Fernbedienung in einem zylindrischen Aufnahmeraum an einem Tragekörper eine Mantelwand, die wenigstens teilweise um eine Mantelseite des Aufnahmeraumes gelegt ist eine sich an einer Grundseite des Aufnahmeraumes an die Mantelwand anschließende Bodenwand mit einer in den Aufnahmeraum gerichteten Innenseite und einer der Innenseite gegenüberliegenden Außenseite und eine Einsetzöffnung an einer Deckseite des Aufnahmeraumes, über die die Fernbedienung in den Aufnahmeraum einsetzbar ist, wobei durch die Bodenwand zwei Durchgangsöffnungen geführt sind, durch die jeweils ein Befestigungsmittel zur Befestigung der Bodenwand am Tragekörper führbar sind, und wobei in die Bodenwand von der Außenseite her eingelassen zwei Kammern angeordnet sind, in denen sich je ein Magnet zum Halten der Fernbedienung im Aufnahmeraum befindet.

Der angegebenen Wandhalterung liegt die Überlegung zugrunde, dass Fernbedienungen für bestimmte Geräte eher stationär an einer Wand bedient werden, während der Benutzer sie nur selten von der Wand genommen an einem anderen Ort bedient. Ein Beispiel für ein solches Gerät ist eine Klimaanlage in einem Hotel. Die Fernbedienung wird in der Regel an einem festen Ort an der Wand in einer Wandhalterung gehalten und dort auch wie ein Lichtschalter bedient. Nur in Ausnahmefällen wird die Fernbedienung tatsächlich entfernt.

In der eingangs genannten Wandhalterung wird die Fernbedienung in einer Art Korb gehalten, der allerdings die Frontseite der Fernbedienung zum Teil verdeckt, so dass nicht gesamte Frontseite für das Tastenbild verwendet werden kann, wenn die Fernbedienung in der Wandhalterung gehalten ist. Alternativ könnte die Fernbedienung auch mit Haken oder anderen Rastmechanismen gehalten werden, die allerdings technisch mit Schwierigkeiten verbunden sind, weil Haken beispielsweise mechanisch beansprucht werden und so brechen können.

Mit dem Halt mittels Magnetkräften umgeht die angegebene Wandhalterung das Problem der mechanischen Beanspruchung so dass die Fernbedienung aus der angegebenen Wandhalterung beliebig oft herausgenommen werden kann, ohne dass Abnutzungserscheinungen auftreten. Zudem ist durch die Anordnung der Magnete in der Bodenplatte hinter dem Aufnahmeraum gewährleistet, dass die Magnete nicht über den Aufnahmeraum entnehmbar sind. Dies bietet insbesondere im zuvor erwähnten Hotel einen Diebstahlschutz.

In einer Weiterbildung der angegebenen Wandhalterung sind die Magnete in den entsprechenden Kammern formschlüssig gehalten. Auf diese Weise sind die Magnete unbeweglich in den Kammern gehalten und verursachen keine Geräusche, wenn die Fernbedienung in den Aufnahmeraum eingesetzt werden und die Magnetkräfte zwischen den Magneten und der Fernbedienung wirken.

In einer zusätzlichen Weiterbildung der angegebenen Wandhalterung ist für den Formschluss in jeder Kammer ein Ring mit einem Abstand zu einer Wandung der jeweiligen angeordnet, in dem der jeweilige Magnet gehalten ist. Der Ring kann sich innerhalb des Abstandes zur Wandung der jeweiligen Kammer Ausdehnen und so neben dem Formschluss auch einen Kraftschluss bereitstellen, so dass beispielsweise bei der Montage der Wandhalterung die Magnete nicht einfach aus den Kammern herausfallen können.

In einer anderen Weiterbildung der angegebenen Wandhalterung ist zwischen den beiden Durchgangsöffnungen eine weitere Kammer ausgebildet. Diese weitere Kammer wirkt einerseits stabilisierend, andererseits könnten in dieser Kammer weitere Magnete untergebracht werden, um die Haltekraft für die Fernbedienung im Aufnahmeraum zu erhöhen.

In einer zusätzlichen Weiterbildung der angegebenen Wandhalterung sind die Kammern von einer umlaufenden Umfassungswand eingeschlossen, die von der Bodenwand in den Aufnahmeraum hinein ragt. Auch diese Umfassungswand erhöht die Stabilität der angegebenen Wandhalterung und verstrebt die Kammern mit den Magneten gegeneinander.

In einer besonderen Weiterbildung der angegebenen Wandhalterung ist die Umfassungswand gesehen von der Bodenwand größer, als die Kammern, so dass die Umfassungswand oberhalb der Kammern einen Einsetzraum definiert, in die ein Deckel einsetzbar ist. Mit diesem Deckel lassen sich die Befestigungsmittel verstecken, wodurch ein Anreiz, die Wandhalterung vom Tragekörper unberechtigt abzunehmen (Diebstahl) gesenkt wird.

Erfindungsgemäß umfasst die angegebene Wandhalterung eine auf die Bodenwand in den Aufnahmeraum hineinragende Auflagerippe, die um die Kammern herum mit einer Höhe über der Bodenwand gelegt ist, welche die Kammern überragt, so dass die Fernbedienung auf die Auflagerippe auflegbar ist. Auf dieser Auflagerippe liegt die im Aufnahmeraum gehaltene Fernbedienung stabil und wackelfrei auf, so dass der Benutzer ein Tastenfeld der Fernbedienung ohne Einschränkungen frei bedienen kann.

In einer zusätzlichen Weiterbildung umfasst die angegebene Fernbedienung Stabilisierungsrippen, welche die Auflagerippe mit der Mantelwand und/oder mit der Umfassungswand und/oder mit sich selbst verbinden. Auf diese Weise wird die Auflagerippe gegen ein Verknicken geschützt, so dass die Auflagerippe vergleichsweise dünn ausgeführt werden kann, selbst wenn für sie als Material ein Kunststoff gewählt wird.

In einer noch weiteren Weiterbildung umfasst die angegebene Wandhalterung eine Öffnung zwischen der Bodenwand und der Mantelwand, durch die ein Werkzeug führbar ist, um die Fernbedienung aus dem Aufnahmeraum zu drücken. Auf diese Weise ist die Fernbedienung aus der angegebenen Wandhalterung in einfacher Weise entnehmbar.

In einer bevorzugten Weiterbildung der angegebenen Wandhalterung ist die Aufnahmeöffnung durch die Auflagerippe geführt, so dass das Werkzeug tief in den Aufnahmeraum einführbar ist und sich beim Herausdrücken der Fernbedienung vergleichsweise hohe Hebelkräfte aufbringen lassen.

In einer besonders bevorzugten Weiterbildung ist die angegebene Wandhalterung als Spritzgussteil ausgeführt. Hierbei sind die Magnete selbstverständlich nicht in dem Spritzgussteil enthalten, sondern werden erst nach der Herstellung in die Kammern des Spritzgussteiles eingesetzt.

Gemäß einem weiteren Aspekt der Erfindung umfasst ein System eine der angegebenen Wandhalterungen und eine im Aufnahmeraum der Vorrichtung angeordnete Fernbedienung mit einem magnetischen Gehäuse, so dass die Magnete in den Kammern die Fernbedienung im Aufnahmeraum halten.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
Fig. 1 eine Wandhalterung in einer perspektivischen Ansicht,
Fig. 2 die Wandhalterung aus Fig. 1 in einer Sicht auf ihren Boden,
Fig. 3 einen Grundkörper der Wandhalterung aus Fig. 1,
Fig. 4 die Wandhalterung aus Fig. 1 in einer Sicht in ihren Aufnahmeraum und mit einem eingesetzten Deckel, und
Fig. 5 ein System mit Wandhalterung aus Fig. 1, in der eine Fernbedienung eingesetzt ist.

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

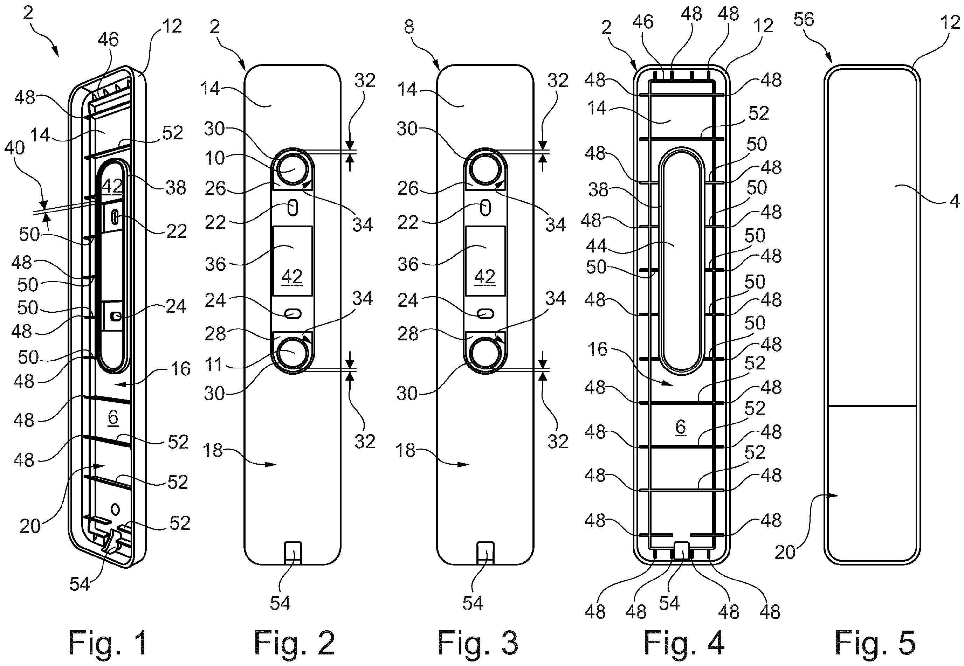

Es wird auf Fig. 1 und 2 Bezug genommen, die aus verschiedenen Perspektiven eine Wandhalterung 2 zum Halten einer in Fig. 5 zu sehenden Fernbedienung 4 in einem zylindrischen Aufnahmeraum 6 an einem nicht weiter zu sehenden Tragekörper zeigt. Der Tragekörper kann beispielsweise eine Zimmerwand sein, an der die Wandhalterung 2 befestigt ist, wobei die Fernbedienung 4 zur Steuerung einer Klimaanlage oder dergleichen eingerichtet sein kann.

Die Wandhalterung 2 ist aus einem in Fig. 3 abgebildeten Grundkörper 8, aufgebaut, in den in einer noch zu beschreibenden Weise ein erster Magnet 10 und ein zweiter Magnet 11 eingesetzt sind. Das ,S' in den Magneten der Figs. deutet an, dass der Südpol der Magnete aus der Zeichnungsebene herausgerichtet angeordnet ist. Der Grundkörper 8 kann vollständig als ein urgeformtes Werkstück, wie beispielsweise ein Spritzgussteil gefertigt sein.

Der Grundkörper 8 umfasst eine Mantelwand 12, die wenigstens teilweise um eine nicht weiter referenzierte Mantelseite des Aufnahmeraumes 6 gelegt ist. Ferner umfasst der Grundkörper 8 eine sich an einer nicht weiter referenzierten Grundseite des Aufnahmeraumes 6 an die Mantelwand 12 anschließende Bodenwand 14 mit einer in den Aufnahmeraum 6 gerichteten Innenseite 16 und einer der Innenseite 16 gegenüberliegenden Außenseite 18. Schließlich umfasst der Grundkörper 8 eine Einsetzöffnung 20 an einer nicht weiter referenzierten Deckseite des Aufnahmeraumes 6, über die die Fernbedienung 4 in den Aufnahmeraum 6 in der in Fig. 5 gezeigten Weise einsetzbar ist.

Durch die Bodenwand 14 sind eine erste Durchgangsöffnung 22 und eine zweite Durchgangsöffnung 24 geführt, durch die jeweils ein Befestigungsmittel zur Befestigung der Bodenwand 14 am Tragekörper führbar sind. Das Befestigungsmittel kann beliebig gewählt werden, zweckmäßigerweise werden in der Regel Schrauben als Befestigungsmittel verwendet. Die Durchgangsöffnungen 22, 24 sind als Langlöcher ausgeführt, wobei die erste Durchgangsöffnung 22 senkrecht zur zweiten Durchgangsöffnung 24 angeordnet ist. Auf diese Weise lässt sich eine Lage des Grundkörpers 8 und damit der Wandhalterung 2 am Tragekörper in an sich bekannter Weise ausrichten.

Die Durchgangsöffnungen 22, 24 sind auf einer gedachten Linie angeordnet und befinden sich zwischen einer ersten Kammer 26 und einer zweiten Kammer 28, die in die Bodenwand 14 des Grundkörpers 8 von der Außenseite her eingelassenen sind. Dabei sind die beiden Kammern 26, 28 auf der zuvor genannten gedachten Linie durch die beiden Durchgangsöffnungen 22, 24 in zueinander spiegelsymmetrischer Weise angeordnet. In der ersten Kammer 26 befindet sich der oben genannte erste Magnete 10, während sich in der zweiten Kammer 28 der oben genannte zweite Magnet 11 befindet. Beide Magnete 10, 11 halten durch ihre Magnetkraft die Fernbedienung 4 im Aufnahmeraum 6 in der in Fig. 5 gezeigten Weise, wenn sich an der Fernbedienung 4 ein entsprechendes magnetisches Gegenelement befindet. Dies kann zum Beispiel ein magnetisierbares metallisches Gehäuse sein.

Die Magnete 10, 11 sind in ihren entsprechenden Kammern 26, 28 formschlüssig gehalten. Hierzu ist in jeder Kammer 26, 28 ein Ring 30 mit einem Abstand 32 zu einer Wandung 34 der jeweiligen Kammer 26, 28 angeordnet ist. In jedem der Ringe 30 ist jeweils ein Magnet 10, 11 gehalten.

Zwischen den beiden Durchgangsöffnungen 22, 24 ist eine weitere Kammer 36 ausgebildet, in der grundsätzlich ebenfalls Magnete angeordnet werden könnten. In der vorliegenden Ausführung ist die weitere Kammer 36 allerdings rein aus Stabilitätsgründen vorhanden.

Die drei Kammern 26, 28, 36 sind von einer umlaufenden Umfassungswand 38 eingeschlossen oder umgeben, die von der Bodenwand 14 in den Aufnahmeraum 6 hinein ragt. Dabei ist die Umfassungswand 38 gesehen von der Bodenwand 14 größer, als die Kammern 26, 28, 36. Das heißt, die Umfassungswand 38 überragt die Kammern 26, 28, 36 mit einem Überstand 40. Dieser Überstand 40 grenzt oder definiert aus Sicht der Innenseite 16 der Bodenwand 14 oberhalb der Kammern 26, 28, 36 einen Einsetzraum 42, in den sich ein in Fig. 4 abgebildeter Deckel 44 einsetzen lässt.

Ferner umfasst der Grundkörper 8 der Wandalterung 2 eine auf die Innenseite 16 der Bodenwand 14 aufgesetzte und in den Aufnahmeraum 6 hineinragende Auflagerippe 46. Die Auflagerippe 46 ist um die Kammern 26, 28, 36 sowie um die Umfassungswand 38 herumgelegt und überragt die Kammern 26, 28, 36 mit einer Höhe, die gleich dem Überstand 40 ist. Das heißt, die Umfassungswand 38 und die Auflagerippe 46 besitzen aus Sicht der Innenseite 16 der Bodenwand 14 die gleiche Höhe. Ein nicht weiter referenzierter mittlerer Abstand der Auflagerippe 46 von der Mantelwand 12 ist dabei um ein Vielfaches kleiner als ein nicht weiter referenzierter mittlerer Abstand den Kammern 26, 28, 36 sowie der Umfassungswand 28. Auf diese Weise liegt die Fernbedienung auf der Auflagerippe 46 stabil auf, wenn sie in den Aufnahmeraum 6 eingesetzt ist.

Zur Stabilisierung umfasst der Grundkörper 8 der Wandhalterung 2 ferner drei verschiedene Arten von Stabilisierungsrippen. Erste Stabilisierungsrippen 48 verbinden dabei die Auflagerippe 46 mit der Mantelwand 12. Von diesen ersten Stabilisierungsrippen 48 sind in den Figs. der Übersichtlichkeit halber nicht alle mit einem eigenen Bezugszeichen versehen. Zweite Stabilisierungsrippen 50 verbinden die Auflagerippe 46 mit der Umfassungswand 38. Auch von den zweiten Stabilisierungsrippen 50 sind in den Figs. der Übersichtlichkeit halber nicht alle mit einem eigenen Bezugszeichen versehen. Schließlich verbinden dritte Stabilisierungsrippen 52 die Auflagerippe 46 untereinander. Von den dritten Stabilisierungsrippen 52 sind in den Figs. der Übersichtlichkeit halber nicht alle mit einem eigenen Bezugszeichen versehen.

Um die Fernbedienung 4 aus der Wandhalterung 2 entfernen zu können umfasst der Grundkörper 8 eine Öffnung 54 zwischen der Bodenwand 14 und der Mantelwand 12. Durch die Öffnung 54 lässt sich ein nicht weiter gezeigtes Werkzeug beispielsweise in Form eines Schraubendrehers führen und die Fernbedienung 4 aus dem Aufnahmeraum 6 drücken. Hierzu kann ein Rand der Öffnung 54 als Hebelpunkt verwendet werden, wobei das Werkzeug beim Drücken um diesen Hebelpunkt gedreht wird. Damit sich das Werkzeug möglichst tief in die Aufnahmeöffnung 6 einführen lässt, kann die Öffnung ferner durch die Auflagerippe 48 und weiter optional durch die nächste dritte Stabilisierungsrippe 52 geführt sein. geführt ist.

Ein System 56 aus der Wandhalterung 2 und die in den Aufnahmeraum 6 der Wandhalterung 2 eingesetzte Fernbedienung 4 ist in Fig. 5 zu sehen.

## Patentansprüche

1. Wandhalterung (2) mit einem zylindrischen Aufnahmeraum (6) zum Halten einer Fernbedienung (4) in dem zylindrischen Aufnahmeraum (6) an einem Tragekörper, umfassend
- eine Mantelwand (12), die wenigstens teilweise um eine Mantelseite des Aufnahmeraumes (6) gelegt ist,
- eine sich an einer Grundseite des Aufnahmeraumes (6) an die Mantelwand (12) anschließende Bodenwand (14) mit einer in den Aufnahmeraum (6) gerichteten Innenseite (16) und einer der Innenseite (16) gegenüberliegenden Außenseite (18), und
- eine Einsetzöffnung (20) an einer Deckseite des Aufnahmeraumes (6), über die die Fernbedienung (4) in den Aufnahmeraum (6) einsetzbar ist,
- wobei durch die Bodenwand (14) zwei Durchgangsöffnungen (22, 24) geführt sind, durch die jeweils ein Befestigungsmittel zur Befestigung der Bodenwand (14) am Tragekörper führbar sind, und
- **dadurch gekennzeichnet, dass**
in die Bodenwand (14) von der Außenseite (18) her zwei Kammern (26, 28) eingelassen angeordnet sind, in denen sich je ein Magnet (10, 11) zum Halten der Fernbedienung (4) im Aufnahmeraum (6) befindet,
- wobei die Wandhalterung (2) ferner eine auf die Bodenwand (12) in den Aufnahmeraum (6) hineinragende Auflagerippe (46) umfasst, die um die Kammern (26, 28, 36) herum mit einer Höhe über der Bodenwand (14) gelegt ist, welche die Kammern (26, 28, 36) überragt (40), so dass die Fernbedienung (4) auf die Auflagerippe (46) auflegbar ist.

2. Wandhalterung (2) nach Anspruch 1, wobei die Magnete (10, 11) in den entsprechenden Kammern (26, 28) formschlüssig gehalten sind.

3. Wandhalterung (2) nach Anspruch 2, wobei für den Formschluss in jeder Kammer (26, 28) ein Ring (30) mit einem Abstand (32) zu einer Wandung (34) der jeweiligen Kammer (26, 28) angeordnet ist, in dem der jeweilige Magnet (10, 11) gehalten ist.

4. Wandhalterung (2) nach einem der vorstehenden Ansprüche, wobei zwischen den beiden Durchgangsöffnungen (22, 24) eine weitere Kammer (36) ausgebildet ist.

5. Wandhalterung (2) nach einem der vorstehenden Ansprüche, wobei die Kammern (26, 28, 36) von einer umlaufenden Umfassungswand (38) eingeschlossen sind, die von der Bodenwand (14) in den Aufnahmeraum (6) hinein ragt.

6. Wandhalterung (2) nach Anspruch 5, wobei die Umfassungswand (38) gesehen von der Bodenwand (12) größer (40) ist, als die Kammern (26, 28, 36), so dass die Umfassungswand (38) oberhalb der Kammern (26, 28, 36) einen Einsetzraum (42) definiert, in die ein Deckel (44) einsetzbar ist.

7. Wandhalterung (2) nach einem der vorstehenden Ansprüche, umfassend Stabilisierungsrippen (48, 50, 52), welche die Auflagerippe (46) mit der Mantelwand (12) und/oder mit der Umfassungswand (38) und/oder mit sich selbst (46) verbinden.

8. Wandhalterung (2) nach einem der vorstehenden Ansprüche, umfassend eine Öffnung (54) zwischen der Bodenwand (14) und der Mantelwand (12), durch die ein Werkzeug führbar ist, um die Fernbedienung aus dem Aufnahmeraum zu drücken, wobei die Aufnahmeöffnung vorzugsweise durch die Auflagerippe (46) geführt ist.

9. System (56), umfassend:
- eine Wandhalterung (2) nach einem der vorstehenden Ansprüche, und
- eine im Aufnahmeraum (6) der Wandhalterung (2) angeordnete Fernbedienung (4) an der ein magnetisierbares Element gehalten ist, so dass die Magnete (10, 11) in den Kammern (26, 28) die Fernbedienung (4) im Aufnahmeraum (6) halten.

## Claims

1. Wall mount (2) having a cylindrical receiving space for holding a remote control (4) in the cylindrical receiving space (6) on a support body, comprising
- a jacket wall (12) at least partially wrapped around a jacket side of the receiving space (6)
- a bottom wall (14) adjoining the jacket wall (12) on a base side of the receiving space (6) and having an inner side (16) directed into the receiving space (6) and an outer side (18) opposite the inner side (16), and
- an insertion opening (20) on a deck side of the receiving space (6), via which the remote control (4) can be inserted into the receiving space (6),
- wherein two through-openings (22, 24) are guided through the bottom wall (14), through each of which a fastening means for fastening the bottom wall (14) to the carrying body can be guided, and
- **characterised in that** two chambers (26, 28) are arranged in the base wall (14) from the outside (18), in each of which chambers there is a magnet (10, 11) for holding the remote control (4) in the receiving space (6),
- wherein the wall holder (2) further comprises a support rib (46) projecting onto the floor wall (12) into the receiving space (6), which rib is placed around the chambers (26, 28, 36) with a height above the floor wall (14) which projects (40) beyond the chambers (26, 28, 36), so that the remote control (4) can be placed onto the support rib (46).

2. Wall mounting (2) according to claim 1, wherein the magnets (10, 11) are positively held in the corresponding chambers (26, 28).

3. Wall mounting (2) according to claim 2, wherein for the positive locking in each chamber (26, 28) a ring (30) is arranged at a distance (32) from a wall (34) of the respective chamber (26, 28), in which the respective magnet (10, 11) is held.

4. Wall mount (2) according to one of the preceding claims, wherein a further chamber (36) is formed between the two through openings (22, 24).

5. Wall bracket (2) according to one of the preceding claims, wherein the chambers (26, 28, 36) are enclosed by a circumferential enclosing wall (38) which projects from the bottom wall (14) into the receiving space (6).

6. Wall bracket (2) according to claim 5, wherein the enclosing wall (38), seen from the bottom wall (12), is larger (40) than the chambers (26, 28, 36), so that the enclosing wall (38) above the chambers (26, 28, 36) defines an insertion space (42) into which a cover (44) is insertable.

7. Wall bracket (2) according to one of the preceding claims, comprising stabilising ribs (48, 50, 52) connecting the support rib (46) to the jacket wall (12) and/or to the enclosure wall (38) and/or to itself (46).

8. Wall bracket (2) according to one of the preceding claims, comprising an opening (54) between the bottom wall (14) and the casing wall (12), through which a tool can be guided in order to press the remote control out of the receiving space, wherein the receiving opening is preferably guided by the support rib (46).

9. System (56) comprising:
- a wall mount (2) according to any one of the preceding claims, and
- a remote control (4) disposed in the receiving space (6) of the wall mount (2), to which a magnetisable element is held so that the magnets (10, 11) in the chambers (26, 28) hold the remote control (4) in the receiving space (6).

## Revendications

1. Support mural (2) avec un espace de réception cylindrique pour maintenir une télécommande (4) dans l'espace de réception cylindrique (6) sur un corps de support, comprenant
- une paroi d'enveloppe (12) qui est placée au moins partiellement autour d'un côté d'enveloppe de l'espace de réception (6),
- une paroi de fond (14) se raccordant à la paroi d'enveloppe (12) sur un côté de base de l'espace de réception (6), avec un côté intérieur (16) orienté vers l'espace de réception (6) et un côté extérieur (18) opposé au côté intérieur (16), et
- une ouverture d'insertion (20) sur un côté supérieur de l'espace de réception (6), par laquelle la télécommande (4) peut être insérée dans l'espace de réception (6),
- la paroi de fond (14) étant traversée par deux ouvertures de passage (22, 24) à travers lesquelles on peut faire passer respectivement un moyen de fixation pour fixer la paroi de fond (14) au corps de support, et
- **caractérisé en ce que** deux chambres (26, 28) sont disposées dans la paroi de fond (14) à partir du côté extérieur (18), chambres dans lesquelles se trouve respectivement un aimant (10, 11) pour maintenir la télécommande (4) dans l'espace de réception (6),
- le support mural (2) comprenant en outre une nervure d'appui (46) faisant saillie sur la paroi de fond (12) dans l'espace de réception (6), qui est placée autour des chambres (26, 28, 36) avec une hauteur au-dessus de la paroi de fond (14) qui dépasse (40) les chambres (26, 28, 36), de sorte que la télécommande (4) peut être posée sur la nervure d'appui (46).

2. Support mural (2) selon la revendication 1, dans lequel les aimants (10, 11) sont maintenus par complémentarité de forme dans les chambres correspondantes (26, 28).

3. Support mural (2) selon la revendication 2, dans lequel, pour la liaison par complémentarité de forme, une bague (30) est disposée dans chaque chambre (26, 28) à une distance (32) d'une paroi (34) de la chambre (26, 28) correspondante, dans laquelle l'aimant (10, 11) correspondant est maintenu.

4. Support mural (2) selon l'une des revendications précédentes, dans lequel une autre chambre (36) est formée entre les deux ouvertures de passage (22, 24).

5. Support mural (2) selon l'une des revendications précédentes, dans lequel les chambres (26, 28, 36) sont enfermées par une paroi périphérique (38) qui fait saillie dans l'espace de réception (6) à partir de la paroi de fond (14).

6. Support mural (2) selon la revendication 5, dans lequel la paroi périphérique (38), vue depuis la paroi de fond (12), est plus grande (40) que les chambres (26, 28, 36), de sorte que la paroi périphérique (38) définit, au-dessus des chambres (26, 28, 36), un espace d'insertion (42) dans lequel un couvercle (44) peut être inséré.

7. Support mural (2) selon l'une des revendications précédentes, comprenant des nervures de stabilisation (48, 50, 52) reliant la nervure d'appui (46) à la paroi d'enveloppe (12) et/ou à la paroi d'enceinte (38) et/ou à elle-même (46).

8. Support mural (2) selon l'une des revendications précédentes, comprenant une ouverture (54) entre la paroi de fond (14) et la paroi d'enveloppe (12), à travers laquelle un outil peut être guidé pour pousser la télécommande hors de l'espace de réception, l'ouverture de réception étant de préférence guidée par la nervure d'appui (46).

9. Système (56) comprenant :
- un support mural (2) selon l'une des revendications précédentes, et
- une télécommande (4) disposée dans l'espace de réception (6) du support mural (2), sur laquelle un élément magnétisable est maintenu, de sorte que les aimants (10, 11) dans les chambres (26, 28) maintiennent la télécommande (4) dans l'espace de réception (6).
